(19) Europäisches Patentamt / European Patent Office / Office européen des brevets

(11) **EP 3 415 957 B1**

(12) **FASCICULE DE BREVET EUROPEEN**

(45) Date de publication et mention de la délivrance du brevet:
**20.07.2022  Bulletin 2022/29**

(21) Numéro de dépôt: **18305611.8**

(22) Date de dépôt: **17.05.2018**

(51) Classification Internationale des Brevets (IPC):
**G01V 99/00** (2009.01)    **G01V 1/30** (2006.01)
**G01V 11/00** (2006.01)

(52) Classification Coopérative des Brevets (CPC):
**G01V 1/306; G01V 11/00; G01V 99/005;**
G01V 2210/624; G01V 2210/64; G01V 2210/661

(54) **PROCÉDÉ D'EXPLOITATION D'UN BASSIN SÉDIMENTAIRE COMPORTANT DES HYDROCARBURES, AU MOYEN D'UNE MODELISATION DE L'ACCUMULATION DE LA MATIÊRE ORGANIQUE TERRESTRE**

VERFAHREN ZUM AUSBEUTEN EINES KOHLENWASSERSTOFFEN UMFASSENDEN SEDIMENTBECKENS MITHILFE VON EINEM MODEL DER AKKUMULIERUNG DES ORGANISCHEN MATERIALS IM UNTERGRUND

METHOD FOR EXPLOITING A SEDIMENTARY BASIN COMPRISING HYDROCARBONS WITH THE HELP OF A MODELING OF THE ACCUMULATION OF THE EARTH ORGANIC MATTER

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité:  **13.06.2017   FR 1755284**

(43) Date de publication de la demande:
**19.12.2018   Bulletin 2018/51**

(73) Titulaire: **IFP Energies nouvelles**
**92852 Rueil-Malmaison Cedex (FR)**

(72) Inventeurs:
• **CHAUVEAU, Benoit**
**78420 Carrieres Sur Seine (FR)**
• **PUJOL, Arnaud**
**92500 Rueil Malmaison (FR)**
• **AGELAS, Léo**
**92150 Suresnes (FR)**
• **GRANJEON, Didier**
**78110 Le Vesinet (FR)**

(74) Mandataire: **IFP Energies nouvelles**
**Département Propriété Industrielle**
**Rond Point de l'échangeur de Solaize**
**BP3**
**69360 Solaize (FR)**

(56) Documents cités:
**EP-A1- 2 743 738        FR-A1- 2 744 224**
**FR-A1- 2 830 646        US-A1- 2007 265 782**
**US-A1- 2015 066 461**

• **RÉMY DESCHAMPS ET AL: "The coal-bearing strata of the Lower Cretaceous Mannville Group (Western Canadian Sedimentary Basin, South Central Alberta). Part 1: Stratigraphic architecture and coal distribution controlling factors", INTERNATIONAL JOURNAL OF COAL GEOLOGY, vol. 179, 1 juin 2017 (2017-06-01), pages 113-129, XP055447980, AMSTERDAM, NL ISSN: 0166-5162, DOI: 10.1016/j.coal.2017.05.019**

## Description

La présente invention concerne le domaine de l'exploration et de l'exploitation des gisements pétroliers ou de sites de stockage géologique de gaz.

L'exploration pétrolière consiste à rechercher des gisements d'hydrocarbures au sein d'un bassin sédimentaire. La compréhension des principes de la genèse des hydrocarbures et leurs liens avec l'histoire géologique du sous-sol, a permis la mise au point de méthodes d'évaluation du potentiel pétrolier d'un bassin sédimentaire. La démarche générale de l'évaluation du potentiel pétrolier d'un bassin sédimentaire comporte des allers-retours entre une prédiction du potentiel pétrolier du bassin sédimentaire, réalisée à partir d'informations mesurées relatives au bassin étudié (analyse d'affleurements, campagnes sismiques, forages par exemple), et des forages d'exploration dans les différentes zones présentant le meilleur potentiel, afin de confirmer ou infirmer le potentiel prédit préalablement, et d'acquérir de nouvelles informations permettant de préciser les prédictions de potentiel pétrolier du bassin étudié.

L'exploitation pétrolière d'un gisement consiste, à partir des informations récoltées lors de la phase d'exploration pétrolière, à sélectionner les zones du gisement présentant le meilleur potentiel pétrolier, à définir des schémas d'exploitation pour ces zones (par exemple à l'aide d'une simulation de réservoir, afin de définir les nombre et positions des puits d'exploitation permettant une récupération d'hydrocarbures optimale), à forer des puits d'exploitation et, de façon générale, à mettre en place les infrastructures de production nécessaires au développement du gisement.

L'évaluation du potentiel pétrolier d'un bassin sédimentaire peut se faire soit de manière probabiliste soit de manière analytique. L'approche analytique est le plus souvent mise en œuvre au moyen de logiciels exécutés sur ordinateur, permettant la synthèse des données disponibles et la simulation de l'histoire géologique du bassin étudié. En fonction de la complexité de l'histoire géologique du bassin étudié, la famille des logiciels mis en œuvre pour l'approche analytique peut comprendre la simulation à une, deux ou trois dimensions, des processus sédimentaires, tectoniques, thermiques, hydrodynamiques, de chimie organique et inorganique qui interviennent lors de la formation d'un bassin pétrolier. On parle alors d'une démarche dite de « modélisation de bassin ».

Concernant plus particulièrement la modélisation des processus sédimentaires, on met en œuvre des logiciels dits de modélisation stratigraphique. La modélisation stratigraphique a pour objectif de simuler l'évolution d'un bassin sédimentaire au cours des temps géologiques afin de quantifier notamment la géométrie des couches sédimentaires, le type de sédiments déposés, la profondeur d'eau au moment du dépôt, etc. On connaît des modèles stratigraphiques 3D, résolus de manière numérique, via des logiciels exécutés sur ordinateur, tels que le simulateur stratigraphique DIONISOSFLOW™ (IFP Energies nouvelles, France). De manière générale, les différents modèles stratigraphiques prennent en compte trois grands processus :

- la création (ou la suppression), d'espace disponible à la sédimentation par les mouvements tectoniques, eustatiques et flexuraux,

- l'apport en sédiment dans le bassin, soit par les frontières, soit par l'intermédiaire d'une production ou d'une précipitation in situ, et

- le transport de ces sédiments dans l'espace disponible créé, ces transports peuvent être le transport permanent des sédiments, le transport épisodique des sédiments et/ou le transport catastrophique de ces sédiments.

Une nouvelle stratigraphie est ensuite déterminée sur la base du principe de conservation de la masse.

## Etat de la technique

Les documents suivants seront cités dans la suite de la description :

Bohacs, K and Suter, J. (1997). Sequence Stratigraphic Distribution of Coaly Rocks: Fundamental Controls and Paralic Examples. AAPG Bulletin, V. 81, No. 10 (October 1997), P. 1612-1639.

Granjeon D. et Joseph P. (1999) Concepts and applications of a 3D multiple lithology, diffusive model in stratigraphic modeling. In: Harbaugh J. W., Watney W. L., Rankey E. C., Slingerland R., Goldstein R. H., Franseen E. K. (Eds.). Numerical Experiments in Stratigraphy: Recent Advances in Stratigraphic and Sedimentologic Computer Simulations. SEPM Special Publications, 62, p. 197-210.

Mann, U. and Zweigel, J., (2008). Modelling source rock distribution and quality variations: The OF-Mod approach. In: Analogue and Numerical Forward Modelling of Sedimentary Systems; from Understanding to Prediction (P.L. de Boer, G. Postma, C.J. van der Zwan, P.M. Burgess and P. Kukla, eds.). Special Publication 40 of the International Association of Sedimentologists, pp. 239-274.

L'évaluation du potentiel pétrolier d'un bassin sédimentaire nécessite de caractériser au mieux la distribution des sédiments au sein d'un bassin sédimentaire, et plus particulièrement la distribution et la qualité de la matière organique au sein de ces sédiments, contrôlées par les processus de dépôt, de dégradation et/ou de préservation de cette matière organique. Une bonne caractérisation des couches sédimentaires riches en matière organique passe ainsi notamment par une bonne compréhension de la stratigraphie du bassin, c'est-à-dire de la géométrie des couches sédimentaires, de la répartition des sédiments fins et grossiers au sein de ces couches, et de l'impact qu'aura la dynamique de ce remplissage sur la distribution finale et la qualité de la matière organique.

Majoritairement, les modèles stratigraphiques actuels permettent de retracer l'histoire des dépôts de sédiments inorganiques au sein d'un bassin. Toutefois, l'industrie pétrolière souhaite en plus connaître si, au cours des temps géologiques, le bassin a connu des conditions favorables au dépôt de matière organique et à sa préservation, et la localisation et la qualité de ces dépôts le cas échéant.

Ainsi, il apparaît important de prédire la distribution et la qualité de la matière organique au sein d'un bassin sédimentaire. De manière générale, on peut distinguer trois types de matière organique :

- la matière organique d'origine marine, qui résulte de la production in situ de matière organique, initialement produite en zone photique, puis préservée au cours des temps géologiques ;

- la matière organique lacustre, qui résulte de la production in situ de matière organique, initialement produite en zone photique ou benthique, puis préservée au cours des temps géologiques ;

- la matière organique d'origine terrestre, qui résulte de la production in situ de la matière organique à la surface émergée d'un bassin sédimentaire, puis préservée au cours des temps géologiques.

On connaît le modèle Of-Mod ™ (SINTEF, Norvège) qui permet de prédire la distribution et la qualité de la matière organique déposée en environnement marin dans des séquences stratigraphiques. Ce modèle est notamment décrit dans le document (Mann and Zweigel, 2008). Ce modèle nécessite un modèle numérique 3D du bassin sédimentaire étudié, fourni par un modèle stratigraphique ou un géomodeleur, et quantifie la teneur en carbone organique dans les sédiments en simulant la production et la dégradation de la matière organique. Toutefois, si ce modèle peut être adapté à la prédiction de la distribution et de la qualité de la matière organique marine, la gestion de la matière organique terrestre dans ce modèle est relativement éloignée de la réalité physique. En effet, l'approche décrite dans cette demande repose sur une hypothèse de corrélation entre les apports en sédiments inorganiques et la matière organique terrestre. De plus, ce modèle ne détermine pas de zones de production/préservation de la matière organique terrestre en fonction notamment d'un bilan hydrologique et/ou des circulations de fluide au sein du bassin.

On connaît également la demande EP 2743738 (US 2014/0163883) qui concerne la détermination de la distribution et de la qualité de la matière organique dans un bassin sédimentaire à partir d'un couplage entre un modèle stratigraphique et un modèle de production, dégradation et transport de la matière organique. Toutefois, le modèle de production, dégradation et transport décrit dans cette demande est relativement simpliste dans le cas du dépôt de matière organique terrestre car il ne comprend pas une modélisation réaliste de l'état hydrologique du bassin et/ou des circulations de fluide au sein du bassin. En effet, dans le cas de cette approche, le niveau des nappes phréatiques est supposé proportionnel à un flux d'eau à la surface du bassin, ce qui est une hypothèse qui dans de nombreux cas est éloignée de la réalité. Ainsi, par exemple, cette hypothèse néglige : (1) l'impact très important que peut avoir la présence d'un lac sur la nappe phréatique et donc sur la zone vadose ; (2) l'existence des systèmes de rivières déconnectés des nappes. Ainsi, une telle hypothèse pourrait conduire à ne pas reproduire correctement les environnements palustres (zones de production de matière organique terrestre autour des lacs) ou à surestimer la production de matière organique terrestre dans les hauts topographiques (où rivières et nappes peuvent apparaitre souvent déconnectées).

L'invention a pour objet une méthode permettant d'estimer de façon la plus déterministe possible la distribution de la matière organique d'origine terrestre dans un bassin sédimentaire. Pour ce faire, la présente invention repose sur un couplage entre un modèle stratigraphique, un modèle hydrologique, et un modèle d'accumulation in situ de la matière organique terrestre plus proche de la réalité physique. En particulier, le modèle d'accumulation in situ de la matière organique terrestre tient compte des conditions hydriques au sein du bassin sédimentaire, celles-ci étant déterminées à partir d'un modèle hydrologique plus représentatif de la réalité physique. Par ailleurs, le couplage entre le modèle d'accumulation de la matière organique terrestre et du modèle stratigraphique, permet que la matière organique déposée à un pas de temps donné soit transportée, via la modélisation stratigraphique, à un pas de temps suivant.

Selon une variante de réalisation, la présente invention permet de modéliser, en sus de l'accumulation de la matière organique terrestre préservée à l'endroit de sa zone de production, l'accumulation de la partie non préservée in situ de la matière organique terrestre produite.

## Le procédé selon l'invention

Ainsi, la présente invention concerne un procédé pour exploiter des hydrocarbures au sein d'un bassin sédimentaire selon la revendication 1.

Selon une réalisation de l'invention, chacune des mailles de ladite représentation maillée déterminée au moyen dudit simulateur stratigraphique peut comprendre au moins une propriété relative au faciès lithologique desdits sédiments inorganiques de ladite maille.

Selon une mise en œuvre de l'invention, lesdits paramètres dudit modèle hydrologique peuvent comprendre la conductivité hydraulique en chaque maille de ladite représentation maillée, ladite conductivité hydraulique en une desdites mailles pouvant être déterminée au moins à partir de ladite propriété relative au faciès lithologique desdits sédiments organiques en ladite maille.

Selon une variante de réalisation de l'invention, ledit modèle hydrologique peut délimiter une zone saturée dudit bassin en tenant compte de gradients de pression dans ledit bassin, et on définit alors la base de ladite zone insaturée par le toit de ladite zone saturée.

Selon une mise en œuvre de l'invention, une maille de ladite représentation maillée peut être comprise dans une zone d'accumulation potentielle de ladite matière organique terrestre si :

- ladite épaisseur de ladite zone insaturée audit pas de temps est au plus égale à 1m ; et
- ledit flux d'eau de surface est au plus égal à 10 m$^3$/s.

Selon une mise en œuvre de l'invention, une maille de ladite représentation maillée située dans ladite zone d'accumulation potentielle peut faire partie de ladite zone d'accumulation de ladite matière organique terrestre si ladite épaisseur de ladite zone insaturée dans ladite zone d'accumulation potentielle est invariante au cours dudit pas de temps.

Selon l'invention, ladite zone insaturée est considérée comme stable si une égalité de la forme suivante est vérifiée :

$$Su = SR + SL$$

où $SL$ est un taux de variations eustatiques, SR est un taux de sédimentation relatif au dépôt desdits sédiments organiques et desdits sédiments inorganiques, et $SU$ est un taux de subsidence.

Selon une mise en œuvre de l'invention, on peut déterminer ladite quantité de matière organique terrestre accumulée à partir d'un taux d'accumulation de ladite matière organique terrestre TAM déterminé selon une formule du type :

$$TAM = Su - SRin - SL$$

où $SL$ est un taux de variations eustatiques, $SRin$ est un taux de sédimentation relatif au dépôt desdits sédiments inorganiques, et $SU$ est un taux de subsidence.

En outre, l'invention concerne un produit programme d'ordinateur téléchargeable depuis un réseau de communication et/ou enregistré sur un support lisible par ordinateur et/ou exécutable par un processeur, comprenant des instructions de code de programme pour la mise en œuvre du procédé tel que décrit précédemment, lorsque ledit programme est exécuté sur un ordinateur.

D'autres caractéristiques et avantages du procédé selon l'invention, apparaîtront à la lecture de la description ci-après d'exemples non limitatifs de réalisations, en se référant aux Figures annexées et décrites ci-après.

**Présentation succincte des figures**

- La Figure 1 présente un exemple de représentation maillée issue de la mise en œuvre d'une simulation stratigraphique pour un bassin sédimentaire donné et pour un pas de temps donné.

- La Figure 2 présente une zone saturée et une zone insaturée identifiées au moyen du modèle hydrologique selon l'invention pour le bassin sédimentaire et le pas de temps considérés en Figure 1.

**Description détaillée du procédé**

De façon générale, l'un des objets de l'invention concerne un procédé pour exploiter les hydrocarbures présents au sein d'un bassin sédimentaire. De manière générale, un bassin sédimentaire est formé par des dépôts de sédiments successifs dans le temps. Les sédiments peuvent être inorganiques (tels que des dépôts clastiques, carbonatés etc) ou bien organique (dépôt de matière organique d'origine lacustre, marine et/ou terrestre). La présente invention s'applique dans le cas où le bassin sédimentaire étudié résulte du dépôt de sédiments inorganiques et de sédiments organiques au moins d'origine terrestre. En particulier, la présente invention vise à quantifier de manière fiable la distribution de la matière organique d'origine terrestre s'étant déposée au sein d'un bassin sédimentaire. Par matière organique terrestre, on entend une matière organique qui n'est au moins ni d'origine marine ni d'origine lacustre. La présente invention est particulièrement mais non exclusivement appropriée dans le cas du dépôt de matière organique terrestre dans des environnements de type tourbière.

Le procédé selon l'invention repose sur au moins trois modèles couplés : un modèle stratigraphique permettant de modéliser l'évolution stratigraphique d'un bassin sédimentaire, un modèle hydrologique délimitant notamment la zone insaturée du bassin étudié, et un modèle d'accumulation de la matière organique d'origine terrestre. Selon une mise en œuvre de l'invention, les simulations numériques reposant sur chacun de ces modèles sont exécutées sur ordinateur de manière séquentielle, ou bien, alternativement, les modèles stratigraphiques, hydrologiques et d'accumulation selon l'invention sont résolus simultanément.

La présente invention requiert de disposer de :

- de mesures relatives aux dépôts de sédiments inorganiques du bassin étudié : il s'agit de mesures réalisées in situ, permettant notamment de déterminer l'architecture du bassin à l'actuel, de qualifier les différents dépôts sédimentaires inorganiques (composition minéralogique ou au moins du type de dépôt, épaisseurs, âges, conditions de dépôts etc) ou encore les événements géologiques subis par le bassin au cours des temps géologiques (érosion, subsidence, eustatistme etc). Ces mesures peuvent consister en des études d'affleurements et/ou d'analogue, en des mesures diagraphiques réalisées le long de puits forés dans le bassin étudié, en des échantillons de roche prélevés par exemple par carottage, en des images sismiques obtenues suite à des campagnes d'acquisition sismique. A partir des mesures ainsi réalisées, on peut définir les paramètres d'entrée d'une simulation stratigraphique, tels que la morphologie du bassin (notamment la topographie, mais aussi les limites de couches), les apports en sédiments inorganiques, leur transport pour chaque pas de temps. Par exemple, la morphologie pour un pas temps donné peut être obtenue à partir de la morphologie mesurée à l'actuel (sur une image sismique par exemple) et au moyen d'une restauration structurale, technique bien connue du spécialiste, qui peut par exemple être réalisée au moyen du logiciel KronosFlow (IFP Energies nouvelles, France). De même, les apports en sédiments pour un pas de temps donné peuvent être déterminés à partir du volume de la couche sédimentaire observée à l'actuel, divisé par la durée de la sédimentation, et, le cas échéant, en tenant compte d'un taux de production de matière organique terrestre. Enfin, les paramètres de transport pour un pas de temps donné peuvent être estimés à partir de profils de dépôts établis à partir de l'observation du bassin au temps actuel. Ces mesures peuvent également permettre de définir des paramètres d'entrée du modèle hydrologique et du modèle d'accumulation de matière organique terrestre selon l'invention ;

- de mesures relatives au dépôt de matière organique d'origine terrestre : il s'agit de mesures réalisées in situ, par exemple dans des tourbières existants à l'actuel, dans le bassin étudié ou bien dans un analogue, à partir desquelles on peut déduire notamment un taux de production de matière organique terrestre. Par exemple, on peut mesurer in situ un taux de production de tourbières observables actuellement, puis au moyen d'une méthode de mise à l'échelle (méthode d'« upscaling »), on transcrit ce taux de production déterminé sur une échelle de temps courte (1 à 10 mm/an) en un taux à une échelle de temps plus grande (de l'ordre du million d'années). De manière classique, les taux de production de matière organique terrestre observés aux échelles géologiques sont compris entre 1 et 200 m/Ma. On connaît par exemple le document (Bohacs et Suter, 1997) qui reporte une gamme des taux de production de matière organique en fonction des climats. Ces mesures peuvent permettent de définir des paramètres d'entrée du modèle stratigraphique et du modèle d'accumulation de matière organique terrestre selon l'invention ;

- de mesures relatives à l'hydrologie du bassin : il s'agit de mesures réalisées in situ, permettant notamment de qualifier des paramètres hydrologiques du bassin, à l'actuel et de manière préférée pour des temps géologiques antérieurs. A l'actuel, il peut s'agir de mesures de la pluviométrie, de l'évaporation, des flux des aquifères du bassin étudié. Pour des temps géologiques antérieurs, on peut par exemple extrapoler les mesures actuelles à partir de la connaissance des climats antérieurs déduite de l'observation du bassin à l'actuel, ou on peut supposer que les paramètres de transport sont équivalents à ceux des fleuves actuels, et que la pluviométrie et l'évaporation sont définies en se référant aux zones climatiques actuelles. Ces mesures permettent notamment de définir les paramètres de transport nécessaires en entrée d'une simulation stratigraphique, mais également de définir des paramètres du modèle hydrologique et du modèle d'accumulation de matière organique terrestre selon l'invention ;

- un simulateur stratigraphique : il s'agit d'un logiciel exécuté sur ordinateur visant à reconstituer les processus sédimentaires ayant affecté le bassin depuis un temps géologique t jusqu'au temps actuel. Une simulation stratigraphique numérique est de manière générale implémentée de manière discrète dans le temps, c'est-à-dire qu'une simulation stratigraphique simule l'état stratigraphique du bassin pour une succession de pas de temps. Un pas de temps d'un simulateur stratigraphique correspond à une durée géologique au cours de laquelle des dépôts ou des érosions sédimentaires ont été enregistrées. La simulation de l'histoire du remplissage d'un bassin sédimentaire est réalisée à partir des paramètres d'entrée représentatifs de l'histoire sédimentaire du bassin étudié. Selon une mise en œuvre de l'invention, les paramètres d'entrée d'une simulation stratigraphique sont au moins (1) l'espace disponible pour la sédimentation, lié à des mouvements tectoniques et/ou eustatiques et à la compaction mécanique des sédiments (ou tassement des sédiments sous l'effet du poids des couches sus-jacentes) (2) l'apport en sédiments dans le bassin, soit par les frontières, soit par l'intermédiaire d'une production ou d'une précipitation in situ, (3) le transport de ces sédiments (capacité de transport estimée à partir des caractéristiques du sédiment comme la taille des grains ou encore leur densité, du flux d'eau s'écoulant à la surface du sol et de la pente locale du bassin) dans l'espace disponible créé. Le système d'équations décrivant ces processus peut par exemple être résolu par une discrétisation spatiale en volume fini, et un schéma explicite en volumes finis. De manière classique, à l'issue d'une simulation stratigraphique, on dispose au moins de l'évolution de la topographie du bassin au cours du temps, de la distribution des sédiments dans le temps et l'espace, de la distribution des environnements de dépôt (marin, lacustre ou terrestre), de la localisation dans le temps et l'espace de la côte, et optionnellement du flux d'eau de surface (tel que le ruissèlement). Selon une mise en œuvre de l'invention, la distribution des sédiments au sein du bassin pour un pas de temps donné peut se présenter par une représentation maillée pour laquelle chaque maille est au moins remplie en faciès (par exemple on distingue un grès d'un calcaire, mais on peut également distinguer un calcaire d'un autre calcaire par son pourcentage de marne). De manière analogue, la distribution des environnements de dépôt pour un pas de temps donné peut se présenter sous la forme d'une propriété catégorielle représentative du type d'environnement (marin, lacustre, terrestre) ; les mailles voisines ayant la même valeur de propriété catégorielle appartiennent alors à un même environnement de dépôt. Le modèle stratigraphique selon l'invention ne comprend pas une modélisation de la production de matière organique d'origine terrestre. On peut par exemple trouver une description d'un tel simulateur stratigraphique dans le document (Granjeon et Joseph, 1999). Un exemple d'un tel simulateur stratigraphique est le logiciel DionisosFlow™ (IFP Energies nouvelles, France).

Selon une mise en œuvre de l'invention, le procédé selon l'invention comporte au moins les étapes 1) à 4) suivantes, l'enchainement des étapes 1) à 3) étant appliqué pour au moins un pas de temps de la simulation stratigraphique. Alternativement, les étapes 1) à 3) sont réalisées simultanément, ce qui signifie que les modèles sur lesquels reposent ces étapes sont résolus simultanément. Cette alternative permet une plus grande efficacité en termes de temps de calcul et/ou d'éviter que la solution de l'un des modèles soit fonction de la solution d'un modèle résolu à l'étape précédente.

## 1. Modélisation stratigraphique

## 2. Modélisation hydrologique de la zone insaturée

## 3. Modélisation de l'accumulation de la matière organique terrestre

## 4. Exploitation des hydrocarbures de la formation

De manière préférée, les étapes 1) à 3) sont répétées pour chaque pas de temps de la simulation stratigraphique. Avantageusement, les étapes 1) à 3) sont au moins répétées pour chaque pas de temps de la simulation stratigraphique pour lesquels une modélisation des dépôts de matière organique d'origine terrestre est souhaitée.

## 1. Modélisation stratigraphique

Il s'agit au cours de cette étape de modéliser les dépôts sédimentaires au moins inorganiques au sein du bassin étudié pour le pas de temps considéré. Cette étape est réalisée au moyen d'un simulateur stratigraphique tel que décrit ci-dessus, à partir de paramètres de simulation stratigraphique tels que décrits ci-dessus, ces paramètres étant déterminés au moins à partir de mesures relatives au dépôt de sédiments inorganiques et à l'hydrologie du bassin étudié telles que décrites ci-dessus. Le simulateur stratigraphique selon l'invention peut toutefois permettre la modélisation des dépôts sédimentaires organiques d'origine lacustre et/ou marine.

Selon un mode de réalisation de l'invention, on met en œuvre cette étape au moyen d'un simulateur stratigraphique tel que celui décrit dans le document (Granjeon et Joseph, 1999). Un exemple d'un tel simulateur stratigraphique est le logiciel DionisosFlow™ (IFP Energies nouvelles, France).

Selon l'invention, à l'issue de cette étape, on obtient une représentation maillée représentative au moins de la distribution des sédiments inorganiques au sein dudit bassin pour le pas de temps considéré. Selon une mise en œuvre de l'invention, chacune des mailles de cette représentation est renseignée au moins en termes de faciès lithologique (grès, carbonates etc).

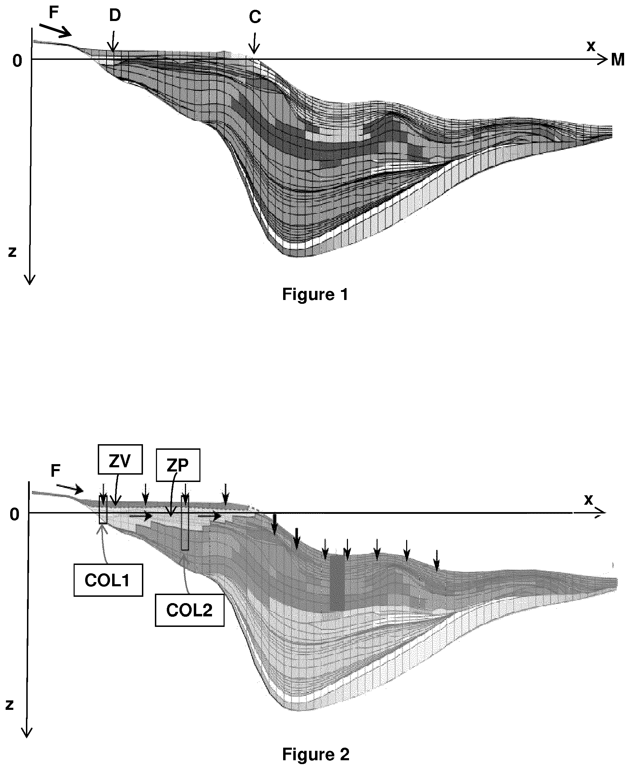

A titre purement illustratif, la Figure 1 présente une section verticale au sein d'une représentation maillée issue d'une simulation stratigraphique pour un pas de temps donné. On peut observer sur cette figure que l'architecture du bassin étudié pour le pas de temps considéré est en forme de cuvette dans laquelle se sont déposés des sédiments successifs, une partie de ces sédiments ayant été apportés dans le bassin par un flux d'eau de surface F, au moins une partie du bassin étant situé sous le niveau de la mer M. On peut également distinguer sur cette figure la limite de la côte C, qui délimite le domaine marin du domaine terrestre. La simulation stratigraphique pour le pas de temps considéré a permis de simuler le dépôt sédimentaire D (couche de mailles la plus en surface du bassin). Il s'agit pour l'exemple illustré d'un dépôt de matière inorganique, déposée dans le domaine terrestre (ou zone continentale).

## 2. Modélisation hydrologique de la zone insaturée

Au cours de cette étape, il s'agit de délimiter la zone insaturée au sein du bassin étudié pour le pas de temps considéré, au moyen d'un modèle hydrologique et de paramètres d'entrée du modèle hydrologique.

De manière générale, un bassin sédimentaire ayant connu un dépôt de matière organique terrestre a, au moins à temps géologique donné, présenté une zone continentale (ou domaine terrestre). On peut notamment déterminer la zone continentale d'un bassin donné à partir des environnements de dépôt tels que déterminés par exemple au moyen d'une simulation stratigraphique. De manière générale, une zone continentale d'un bassin sédimentaire est soumise à un flux de fluide météorique (c'est-à-dire d'origine non marine) et comprend :

  ◦ une zone insaturée ou zone vadose : il s'agit de la partie superficielle de la zone continentale du bassin sédimentaire, non saturée en eau, formée d'eau douce, soumise à des flux hydrologiques liés à la percolation des précipitations au travers du milieu poreux ;
  ◦ une zone saturée ou phréatique : située sous la zone vadose, il s'agit d'une zone saturée en eau douce, soumise à des flux hydrologiques liés au flux des nappes phréatiques souterraines.

Autrement dit, le toit de la zone phréatique correspond à la base de la zone vadose et réciproquement, et le toit de la zone vadose correspond à la topographie du bassin au pas de temps considéré. Selon une mise en œuvre de l'invention, on détermine le toit de la zone phréatique au moyen dudit modèle hydrologique, à partir duquel on déduit la base de la zone vadose.

De manière générale, les paramètres d'entrée du modèle hydrologique selon l'invention sont déterminés à partir d'au moins une partie des mesures relatives aux dépôts de sédiments et à l'hydrologie du bassin telles que décrites précédemment, et d'au moins une partie des informations présentes dans la représentation maillée obtenue à l'issue de l'étape précédente.

Selon une mise en œuvre de l'invention, le modèle hydrologique selon l'invention peut requérir d'une propriété représentative de l'aptitude aux écoulements du milieu poreux contenu dans chaque maille de la représentation maillée, telle que la perméabilité ou la conductivité hydraulique, pour le pas de temps considéré. Selon une mise en œuvre de l'invention, à partir de la représentation maillée remplie en faciès telle qu'obtenue à l'issue de l'étape précédente et à partir d'une table de correspondance entre type de faciès et valeur de conductivité hydraulique, on remplit chaque maille de la représentation maillée en conductivité hydraulique. De telles tables de correspondance sont bien connues du spécialiste. De préférence, on peut avoir recours à des tables de correspondance établies sur la base d'échantillons de roches prélevés au sein du bassin étudié. Selon une autre mise en œuvre de l'invention, la conductivité hydraulique peut être déterminée à partir d'un type de faciès, d'une composition minéralogique et d'une porosité (ces deux dernières propriétés pouvant être obtenues par exemple au moyen d'une simulation stratigraphique ou à partir de tables de correspondance), et au moyen d'une méthode d'homogénéisation telle que décrite dans la demande de brevet EP 3104199.

Selon une mise en œuvre de l'invention, en plus des conductivités hydrauliques, le modèle hydrologique selon l'invention peut en outre requérir des propriétés telles que :

- un taux de précipitations : il s'agit d'un pourcentage représentatif des précipitations survenues au pas de temps considéré. Ce taux de précipitations est prédéfini par le spécialiste en fonction de ses connaissances sur le bassin au pas de temps considéré (par exemple à partir du climat moyen au pas de temps considéré), et notamment à partir de mesures relatives à l'hydrologie et/ou aux dépôts sédimentaires dans le bassin sédimentaire étudié telles que décrites ci-dessus ;

- un coefficient d'infiltration, pondérant l'apport d'eau de la surface (lié aux précipitations) vers le système de nappe phréatique : en effet, seule une partie du flux d'eau lié aux précipitations de surface percole jusqu'à la nappe phréatique. Ce coefficient d'infiltration est par exemple compris entre 1 et 100 %, et est prédéfini par le spécialiste en fonction de ses connaissances sur le bassin au pas de temps considéré, et notamment à partir de mesures relatives à l'hydrologie et/ou aux dépôts sédimentaires dans le bassin étudié telles que décrites ci-dessus ;

- un flux d'eau de surface : il s'agit du flux d'eau se déplaçant le long de la topographie du bassin sédimentaire, lié par exemple aux ruissèlements ou aux cours d'eau présents à la surface du bassin au pas de temps considéré. Le flux d'eau de surface est par exemple compris entre 10 et 1000 $m^3$/s. Il peut être prédéfini par le spécialiste en fonction de ses connaissances sur le bassin au pas de temps considéré. Par exemple, à partir d'une image sismique, le spécialiste peut détecter la présence de chenaux dans une couche géologique, et à partir notamment de la géométrie de ces chenaux, définir un ordre de grandeur du flux d'eau au moment où cette couche était à la surface du bassin. Le flux d'eau de surface au pas de temps considéré peut aussi être issu de la simulation stratigraphique exécuté pour le pas de temps considéré à l'étape précédente. Le simulateur stratigraphique DionisosFlow™ (IFP Energies nouvelles, France) permet notamment une estimation du flux d'eau de surface à chaque pas de temps ;

- la localisation de la côte du bassin sédimentaire : il s'agit de la limite entre le domaine marin et le domaine terrestre, qui se détermine par exemple à partir des environnements de dépôt déterminés à l'issue de la simulation stratigraphique, et de manière générale à partir de la topographie du bassin, de l'eustatisme et de la subsidence au pas de temps étudié.

- la topographie du bassin sédimentaire : il s'agit de la topographie en entrée de la simulation stratigraphique pour le pas de temps considéré. La topographie du bassin sédimentaire évolue au cours du pas de temps, en raison du dépôt de sédiments pour le pas de temps courant et de la subsidence subie par le bassin sédimentaire au cours de ce même pas de temps.

De manière préférée, on peut délimiter au moins le toit de la zone saturée (et donc la base de la zone insaturée) à l'aide d'une équation hydrologique dans laquelle les écoulements dans les nappes phréatiques libres sont conditionnés par des gradients de pression dans le sous-sol. Plus précisément, on peut définir un modèle hydrologique reposant sur une équation du type :

$$S_s \frac{\partial h}{\partial t} - \nabla \cdot (K \nabla h) = Q$$

avec :

- $h$ la charge hydraulique [L],

- le temps [T],

- $K$ le tenseur symétrique de conductivité hydraulique (ou perméabilité) [L.T$^{-1}$],

- $S_s$ le coefficient d'emmagasinement spécifique [L$^{-1}$],

- $Q$ un terme source d'extraction (pompage) [T$^{-1}$].

Le terme source Q d'extraction correspond à la recharge en eau (ou au pompage) de la nappe par les précipitations diminuées de l'évapotranspiration, ainsi qu'aux apports en eau aux frontières de la zone simulée (apport des zones amont et export vers les zones aval). Selon cette mise en œuvre de l'invention, le substratum du bassin sédimentaire est supposé imperméable. La résolution de cette équation permet de déterminer les propriétés hydrauliques (charge hydraulique et vitesse d'écoulement) en tout point du bassin. L'élévation du toit de la nappe phréatique, qui sépare la zone phréatique de la zone vadose, et les gradients de pressions sont déduits des charges calculées. Une telle réalisation du modèle hydrologique permet notamment la détermination du niveau des nappes phréatiques à l'état stationnaire. On peut alors en déduire la localisation de la base de la zone vadose, celle-ci correspondant au toit de la zone phréatique.

A titre purement illustratif, la Figure 2 présente un exemple de mise en œuvre d'un modèle hydrologique pour le même bassin et pour le même pas de temps que celui considéré à la Figure 1. Ainsi le bassin étudié, pour ce pas de temps, comporte une zone vadose météorique ZV et une zone phréatique météorique ZP, le toit de la zone phréatique correspondant à la base de la zone vadose. Sur cette Figure 2 sont également présentés, à titre illustratif, sous la forme de flèches, les flux hydrologiques subis par le bassin étudié : un flux de direction verticale dans la zone vadose ZV, lié à la percolation des précipitations, un flux de direction latérale dans la zone phréatique ZP, lié au déplacement du flux d'eau souterrain sous l'effet des gradients de pression dans le bassin, ainsi que le flux d'eau de surface F lié à la présence d'un fleuve à la surface du bassin. Cette figure présente également l'emplacement de deux colonnes de mailles COL1 et COL2 qui traversent à la fois la zone vadose ZV et la zone phréatique ZP. On peut notamment observer que l'épaisseur de la zone vadose est différente entre ces deux colonnes.

**3. Localisation et quantification de l'accumulation de la matière organique terrestre**

Au cours de cette étape, il s'agit de localiser et quantifier l'accumulation de la matière organique d'origine terrestre au cours du pas de temps considéré. Selon un mode de réalisation de l'invention, cette étape peut être mise en œuvre selon trois sous-étapes :

- à partir de la délimitation de la zone insaturée telle que déterminée à l'étape précédente, on détermine des zones d'accumulation potentielles de la matière organique terrestre ;

- parmi les zones d'accumulation potentielles de la matière organique terrestre, on détermine les zones d'accumulation effectives de la matière organique terrestre ;

- on détermine un taux d'accumulation de la matière organique terrestre dans les zones d'accumulation effectives et on en déduit la quantité de matière organique accumulée.

**3.1.** Détermination des zones d'accumulation potentielles de la matière organique terrestre

Au cours de cette sous-étape, on détermine des zones potentielles d'accumulation F de la matière organique terrestre en considérant deux critères basés sur :

- l'épaisseur de la zone insaturée : en effet, lorsque la zone vadose est de faible épaisseur (par exemple inférieure ou égale à 1m), on peut considérer qu'il s'agit d'une zone « humide », dans laquelle la production de la matière organique terrestre est possible et est même préservée par la présence d'eau qui réduit l'oxydation de la matière organique. A l'opposé, lorsque la zone vadose est épaisse (par exemple supérieure à 1 m), on considère qu'il s'agit d'une région « sèche » non propice à la production de matière organique d'origine terrestre. Selon l'invention, l'épaisseur de la zone insaturée est directement déterminée à partir de la délimitation de la zone insaturée déterminée au moyen du modèle hydrologique selon l'invention, et tel que décrit à l'étape précédente ; et

- le flux d'eau de surface (lié au ruissèlement, aux cours d'eau de surface etc) : en effet, si le flux d'eau est trop important (par exemple au-delà de 10 m³/s), aucun dépôt de matière organique terrestre n'est réalisé, l'environnement étant considéré comme trop perturbé hydrologiquement pour permettre une vie biologique suffisante à la production d'une quantité non négligeable de matière organique terrestre. Le flux d'eau de surface peut être un paramètre issu de la simulation stratigraphique ou bien être un paramètre prédéfini par le spécialiste.

Selon l'invention, lorsque ces deux critères sont satisfaits pour une maille de la représentation maillée, cette maille correspond à une zone d'accumulation potentielle de la matière organique terrestre.

**3.2.** Détermination des zones d'accumulation effectives de la matière organique terrestre

Au cours de cette sous-étape, on détermine si les zones potentielles d'accumulation de la matière organique terrestre sont des zones d'accumulation effectives de la matière organique terrestre en considérant un critère basé sur la stabilité de l'épaisseur de la zone insaturée au cours du pas de temps considéré. En effet, selon l'invention, on considère que si, pour une zone s'accumulation potentielle, l'épaisseur de la zone insaturée :

- diminue au cours du pas de temps, alors l'environnement du bassin sédimentaire étudié est propice à des inondations régulières, ce qui a pour conséquence d'empêcher toute production de matière organique terrestre ;

- augmente au cours du pas de temps, alors l'environnement du bassin sédimentaire étudié s'assèche, ce qui inhibe la production de matière organique et surtout augmente fortement le taux de dégradation de cette matière organique ;

- reste stable au cours du pas de temps, alors les conditions hydriques au sein du bassin sédimentaire permettent la production et la préservation de la matière organique durant le pas de temps considéré.

Selon l'invention, on détermine un taux de stabilité de la zone vadose au cours du pas de temps à partir de la variation de la topographie et du taux de sédimentation dans le bassin étudié au cours de ce même pas de temps. Selon une variante de réalisation de l'invention, on évalue un taux de stabilité de la zone vadose durant un pas de temps en fonction d'un taux de variations eustatiques (SL), d'un taux de sédimentation relatif au dépôt de sédiments organiques et inorganiques (SR), et d'un taux de subsidence (Su). Selon l'invention, on considère que la zone vadose est stable si l'égalité suivante est vérifiée :

$$Su = SR + SL$$

Autrement dit, selon ce mode de mise en œuvre de l'invention, on considère que si le changement topographique associé à la subsidence est compensé par le dépôt de sédiments (organiques et inorganiques) et par les variations eustatiques, alors la zone vadose est stable. Dans le cas où cette égalité n'est pas vérifiée, cela signifie soit que l'épaisseur de la zone vadose augmente, créant ainsi une zone d'inondation non favorable à une production de matière organique, soit que l'épaisseur de la zone vadose diminue, créant une zone d'assèchement, également non favorable à une production de matière organique. Le taux de sédimentation de matière inorganique fait partie des paramètres d'entrée de la simulation stratigraphique et peut être défini à partir des mesures relatives à la stratigraphie telles que définies ci-dessus. Le taux de sédimentation organique peut provenir de mesures relatives aux sédiments organiques telles que décrites ci-dessus, ou bien provenir de documents référençant de tels taux, comme par exemple le document (Bohacs et Suter, 1997).

3.3. Quantification de la matière organique terrestre déposée

Au cours de cette sous-étape, il s'agit de déterminer la quantité de matière organique accumulée dans les zones d'accumulation effectives telles que déterminées à la sous-étape 3.2 décrites précédemment. Selon l'invention, on détermine cette quantité en fonction de l'estimation d'un espace disponible dans chacune des mailles desdites zones d'accumulation effectives.

Selon une mise en œuvre de l'invention, on détermine dans un premier temps un taux d'accumulation de matière organique terrestre au cours du pas de temps à partir de la variation de la topographie, du taux de sédimentation organique terrestre et du taux de sédimentation inorganique dans le bassin étudié au cours de ce même pas de temps. En particulier, selon une variante de réalisation de l'invention, on évalue le taux d'accumulation de matière organique (TAM) durant un pas de temps en fonction des variations eustatiques (SL), de la sédimentation associée au dépôt de sédiments inorganiques (SRin) et organiques (X), et de la subsidence (Su). Le taux de sédimentation de matière organique X est par exemple estimé en se référant au document (Bohacs et Suter, 1997), qui définit des taux de sédimentation organique compris entre 1 et 180 m/Ma en fonction des climats. Par exemple, selon une mise en œuvre de l'invention, si $Su - SRin - SL \leq X$, alors le taux d'accumulation de la matière organique TAM est égale à $TAM = Su -$

*SRin - SL.* Puis, dans un deuxième temps, une fois un taux d'accumulation de matière organique terrestre au cours du pas de temps déterminé, on détermine la quantité de matière organique terrestre accumulée dans chacune des mailles des zones d'accumulation effectives précédemment identifiées, en multipliant le taux d'accumulation de matière organique terrestre ainsi déterminé par la durée du pas de temps.

Selon une mise en œuvre de l'invention au cours de laquelle les étapes 1 à 3 sont répétées pour une succession de pas de temps de la simulation stratigraphique, la quantité de matière organique terrestre accumulée dans une maille donnée à un pas de temps donné peut être transportée vers d'autres mailles de la représentation maillée par l'exécution de la modélisation stratigraphique au pas de temps suivant.

Selon une variante de mise en œuvre de l'invention, lorsque la matière organique terrestre ne peut être totalement accumulée dans la zone de production initiale, à cause d'un espace disponible insuffisant, celle-ci peut être exportée vers une autre zone de dépôt (par exemple un environnement lacustre ou marin). Selon cette variante, à l'issue des sous-étapes 3.1, 3.2 et 3.3, on détermine une quantité de matière organique exportée en faisant la différence entre la quantité de matière organique terrestre produite (égale au taux de production de matière organique retenu pour la mise en œuvre de l'étape 3, multiplié par la durée du pas de temps considéré) et la quantité de matière organique terrestre accumulée in situ (égale au taux d'accumulation de matière organique terrestre déterminé à l'issue de l'étape 3.3, multiplié par la durée du pas de temps). La quantité de matière organique exportée ainsi déterminée peut, au pas de temps suivant, être transportée vers une autre zone de dépôt du bassin sédimentaire étudié, via la modélisation du transport de sédiments de la simulation stratigraphique selon l'invention.

**4- Exploitation des hydrocarbures du bassin sédimentaire**

A partir de la localisation et de la quantification de la matière organique terrestre déposée au sein du bassin sédimentaire pour au moins un pas de temps et de manière préférentielle pour tous les pas de temps de la simulation, on estime le potentiel en hydrocarbures du bassin sédimentaire étudié.

En effet, les hydrocarbures sont issus de la matière organique présente dans le bassin. Ainsi, le potentiel en hydrocarbures peut notamment être estimé à partir de la localisation de la matière organique dans le bassin, de son abondance (on parle de richesse en matière organique), et aussi de son origine (marine, terrestre, lacustre). La présente invention permet notamment de quantifier de manière plus fiable le potentiel en hydrocarbures relatif à de la matière organique d'origine terrestre.

Pour cette quantification, on peut par exemple déterminer le TOC (la teneur en carbone organique), les indices d'hydrogène et oxygène, et la minéralogie de la matière organique au sein des couches du bassin sédimentaire.

Par exemple, l'indice d'hydrogène final dans les matières organiques préservées est calculé en fonction des proportions de chaque type de matière organique présent. Selon une mise en œuvre de l'invention, on peut en outre déterminer un indice d'hydrogène propre à la matière organique terrestre et dont la valeur variable dans le temps et dans l'espace, dépend des conditions de préservation de cette matière organique. Ainsi, on peut par exemple définir la qualité de la matière organique à travers une loi du type, $HI = HIO. \alpha V^{\beta}$ où $HI0$ est le qualité de référence de la matière organique terrestre, et *a* et *b* deux paramètres de calibration permettant de décrire l'impact de la zone vadose sur la qualité de la matière organique terrestre produite dans ces conditions. Ainsi, cette qualité de matière organique terrestre est directement liée aux conditions hydriques de la zone.

De telles propriétés peuvent être par exemple utilisées en entrée d'une simulation de bassin (un exemple d'une telle simulation de bassin est le logiciel Temis-Flow™ (IFP Energies nouvelles, France) qui permet notamment de quantifier le potentiel pétrolier d'un bassin et de déterminer l'emplacement du réservoir pétrolier au sein de ce bassin.

Puis, on définit ensuite un schéma d'exploitation du réservoir identifié au sein de ce bassin. Par exemple, la détermination d'un schéma d'exploitation comprend la définition d'un nombre, d'une géométrie et d'une implantation (position et espacement) de puits injecteurs et producteurs, la détermination d'un type de récupération assistée (par injection d'eau, de tensioactifs, etc.), etc. Un schéma d'exploitation d'un réservoir d'hydrocarbures doit par exemple permettre un fort taux de récupération des hydrocarbures piégés dans le réservoir géologique identifié, sur une longue durée d'exploitation, nécessitant un nombre de puits et/ou d'infrastructures limité. De manière classique, la détermination d'un schéma d'exploitation des hydrocarbures est réalisée à l'aide d'une simulation d'écoulement. Un exemple d'une telle simulation d'écoulement est le logiciel PumaFlow® (IFP Energies nouvelles, France).

Puis, une fois un schéma d'exploitation défini, les hydrocarbures piégés dans le réservoir sont exploités en fonction de ce schéma d'exploitation, notamment en forant les puits injecteurs et producteurs du schéma d'exploitation ainsi déterminé, et en installant les infrastructures de production nécessaires au développement du gisement.

Ainsi, la présente invention repose sur un couplage entre une simulation stratigraphique, un modèle hydrologique et un modèle d'accumulation de la matière organique terrestre permettant la prise en compte de conditions hydriques favorables au dépôt de cette matière organique terrestre et à sa préservation. Plus précisément, la présente invention permet une modélisation de l'évolution des flux hydriques proches de la surface d'un bassin sédimentaire, notamment l'évolution de la zone insaturée de ce bassin, ce qui permet de modéliser de façon plus réaliste la localisation des zones d'accumulation de la matière organique terrestre ainsi que la quantité de matière organique terrestre ainsi accumulée. De cette manière, la présente invention contribue à une meilleure connaissance du potentiel pétrolier du bassin sédimentaire étudié, et permet ainsi de définir des conditions permettant une exploitation optimale de ce bassin.

**Produit programme d'ordinateur**

En outre, l'invention concerne un produit programme d'ordinateur téléchargeable depuis un réseau de communication et/ou enregistré sur un support lisible par ordinateur et/ou exécutable par un processeur, comprenant des instructions de code de programme pour la mise en œuvre du procédé tel que décrit précédemment, lorsque ledit programme est exécuté sur un ordinateur.

**Revendications**

1. Procédé pour exploiter des hydrocarbures au sein d'un bassin sédimentaire, ledit bassin résultant notamment du dépôt de sédiments inorganiques et de matière organique terrestre, ledit procédé étant mis en œuvre à partir de mesures de propriétés relatives auxdits dépôts et à l'hydrologie dudit bassin, au moyen d'un simulateur stratigraphique exécutant sur ordinateur une modélisation stratigraphique pour une succession de pas de temps, **caractérisé en ce que**, pour au moins un pas de temps :

   A. au moyen dudit simulateur et de paramètres dudit simulateur pour ledit pas de temps, lesdits paramètres dudit simulateur étant construits à partir desdites mesures, on détermine une représentation maillée représentative au moins de la distribution desdits sédiments inorganiques au sein dudit bassin pour ledit pas de temps ;
   B. au moyen d'un modèle hydrologique et de paramètres dudit modèle hydrologique, lesdits paramètres dudit modèle hydrologique étant construits à partir desdites mesures et de ladite représentation maillée, on délimite au moins une zone insaturée au sein dudit bassin, ladite zone insaturée correspondant à la zone vadose dudit bassin ;
   C. au moyen d'un modèle d'accumulation de ladite matière organique et de paramètres dudit modèle d'accumulation, lesdits paramètres dudit modèle d'accumulation comprenant l'épaisseur de ladite zone insaturée audit pas de temps, la stabilité de ladite épaisseur de ladite zone insaturée au cours dudit pas de temps, et le flux d'eau de surface audit pas de temps, ladite épaisseur de ladite zone insaturée étant stable si l'égalité suivante est vérifiée :

$$Su = SR + SL$$

où SL est un taux de variations eustatiques, SR est un taux de sédimentation relatif au dépôt desdits sédiments organiques et inorganiques, et Su est un taux de subsidence, on détermine au moins une zone d'accumulation de ladite matière organique terrestre au sein dudit bassin et une quantité de matière organique terrestre accumulée dans ladite zone d'accumulation ;

et **en ce que**, à partir au moins de ladite quantité de matière organique terrestre accumulée et de ladite représentation maillée, on quantifie le potentiel pétrolier dudit bassin, on définit un schéma d'exploitation dudit bassin, et on exploite ledit bassin en fonction dudit schéma.

2. Procédé selon la revendication 1, dans lequel chacune des mailles de ladite représentation maillée déterminée au moyen dudit simulateur stratigraphique comprend au moins une propriété relative au faciès lithologique desdits sédiments inorganiques de ladite maille.

3. Procédé selon la revendication 2, dans lequel lesdits paramètres dudit modèle hydrologique comprennent la conductivité hydraulique en chaque maille de ladite représentation maillée, ladite conductivité hydraulique en une desdites mailles étant déterminée au moins à partir de ladite propriété relative au faciès lithologique desdits sédiments organiques en ladite maille.

4. Procédé selon l'une des revendications précédentes, dans lequel ledit modèle hydrologique délimite une zone saturée dudit bassin en tenant compte de gradients de pression dans ledit bassin, et définit la base de ladite zone insaturée par le toit de ladite zone saturée.

5. Procédé selon l'une des revendications précédentes, dans lequel une maille de ladite représentation maillée est comprise dans une zone d'accumulation potentielle de ladite matière organique terrestre si :

   - ladite épaisseur de ladite zone insaturée audit pas de temps est au plus égale à 1m ; et
   - ledit flux d'eau de surface est au plus égal à 10 m$^3$/s.

6. Procédé selon l'une des revendications précédentes, dans lequel on détermine ladite quantité de matière organique terrestre accumulée à partir d'un taux d'accumulation de ladite matière organique terrestre TAM, ledit taux d'accumulation de ladite matière organique terrestre TAM étant déterminé selon la formule :

$$TAM = Su - SRin - SL$$

lorsque $Su - SRin - SL \leq X$, où $SL$ est ledit taux de variations eustatiques, $SRin$ est un taux de sédimentation relatif au dépôt desdits sédiments inorganiques, X est un taux de sédimentation de ladite matière organique et $Su$ est ledit taux de subsidence.

7. Produit programme d'ordinateur téléchargeable depuis un réseau de communication et/ou enregistré sur un support lisible par ordinateur et/ou exécutable par un processeur, comprenant des instructions de code de programme pour la mise en œuvre du procédé selon l'une des revendications précédentes, lorsque ledit programme est exécuté sur un ordinateur.

**Patentansprüche**

1. Verfahren zur Ausbeutung der Kohlenwasserstoffe innerhalb eines Sedimentbeckens, wobei das Becken insbesondere aus der Ablagerung von anorganischen Sedimenten und von organischem Erdmaterial entstanden ist, wobei das Verfahren anhand von Messungen von Eigenschaften in Bezug auf die Ablagerungen und die Hydrologie des Beckens mittels eines stratigraphischen Simulators durchgeführt wird, der auf einem Computer eine stratigraphische Modellierung für eine Aufeinanderfolge von Zeitschritten ausführt, **dadurch gekennzeichnet, dass** für wenigstens einen Zeitschritt:

A. mittels des Simulators und Parametern des Simulators für den Zeitschritt, wobei die Parameter des Simulators anhand der Messungen erstellt werden, eine Gitterdarstellung bestimmt wird, die wenigstens für die Verteilung der anorganischen Sedimente innerhalb des Beckens für den Zeitschritt repräsentativ ist;
B. mittels eines hydrologischen Modells und Parametern des hydrologischen Modells, wobei die Parameter des hydrologischen Modells anhand der Messungen und der Gitterdarstellung erstellt werden, wenigstens eine ungesättigte Zone innerhalb des Beckens eingegrenzt wird, wobei die ungesättigte Zone der vadosen Zone des Beckens entspricht;
C. mittels eines Speicherungsmodells des organischen Materials und Parametern des Speicherungsmodells, wobei die Parameter des Speicherungsmodells die Dicke der ungesättigten Zone zu dem Zeitschritt, die Stabilität der Dicke der ungesättigten Zone im Verlauf des Zeitschritts und den Strom von Oberflächenwasser zu dem Zeitschritt umfassen, die Dicke der ungesättigten Zone stabil ist, wenn die folgende Gleichheit überprüft ist:

$$Su = SR + SL$$

wobei SL eine Rate eustatischer Variationen, SR eine Sedimentationsrate in Bezug auf die Ablagerung der organischen und anorganischen Sedimente und Su eine Absenkungsrate ist, wenigstens eine Speicherungszone des organischen Erdmaterials innerhalb des Beckens und eine Menge organischen Erdmaterials, die in der Speicherungszone gespeichert ist, bestimmt wird;

und dadurch, dass wenigstens anhand der gespeicherten Menge organischen Erdmaterials und der Gitterdarstellung das Ölpotential des Beckens quantifiziert, ein Ausbeutungsschema des Beckens festgelegt und das Becken nach dem Schema ausgebeutet wird.

2. Verfahren nach Anspruch 1, wobei jede der Maschen der Gitterdarstellung, die mittels des stratigraphischen Simulators bestimmt wird, wenigstens eine Eigenschaft in Bezug auf die lithologische Fazies der anorganischen Sedimente der Masche umfasst.

3. Verfahren nach Anspruch 2, wobei die Parameter des hydrologischen Modells die hydraulische Leitfähigkeit in jeder Masche der Gitterdarstellung umfassen, wobei die hydraulische Leitfähigkeit in einer der Maschen wenigstens anhand der Eigenschaft in Bezug auf die lithologische Fazies der organischen Sedimente in der Masche bestimmt wird.

4. Verfahren nach einem der vorhergehenden Ansprüche, wobei das hydrologische Modell eine gesättigte Zone des Beckens unter Berücksichtigung von Druckgradienten in dem Becken eingrenzt und die Basis der ungesättigten Zone durch das Dach der gesättigten Zone festlegt.

5. Verfahren nach einem der vorhergehenden Ansprüche, wobei eine Masche der Gitterdarstellung in einer potentiellen Speicherungszone des organischen Erdmaterials enthalten ist, wenn:

- die Dicke der ungesättigten Zone zu dem Zeitschritt höchstens gleich 1 m ist; und
- der Strom von Oberflächenwasser höchstens gleich 10 m$^3$/s ist.

**6.** Verfahren nach einem der vorhergehenden Ansprüche, wobei die Menge gespeicherten organischen Erdmaterials anhand einer Speicherungsrate des organischen Erdmaterials, TAM, bestimmt wird, wobei die Speicherungsrate des organischen Erdmaterials TAM gemäß der folgenden Formel bestimmt wird:

$$TAM = Su - SRin - SL$$

wenn *Su - SRin - SL* ≤ X, wobei *SL* die Rate eustatischer Variationen, *SRin* eine Sedimentationsrate in Bezug auf die Ablagerung der anorganischen Sedimente, X eine Sedimentationsrate des organischen Materials und *Su* die Absenkungsrate ist.

**7.** Computerprogrammprodukt, das aus einem Kommunikationsnetz heruntergeladen werden kann und/oder auf einem computerlesbaren Datenträger gespeichert ist und/oder von einem Prozessor ausgeführt werden kann, umfassend Programmcode-Anweisungen für die Umsetzung des Verfahrens nach einem der vorhergehenden Ansprüche, wenn das Programm auf einem Computer ausgeführt wird.

**Claims**

**1.** Method for exploiting for hydrocarbons within a sedimentary basin, said basin resulting in particular from the deposition of inorganic sediments and of terrestrial organic matter, said method being implemented on the basis of measurements of properties relating to these deposits and to the hydrology of said basin, by means of a stratigraphic simulator running, on a computer, a stratigraphic model for a succession of time intervals, **characterized in that**, for at least one time interval:

A. by means of said simulator and parameters of said simulator for said time interval, said parameters of said simulator being constructed on the basis of said measurements, a mesh representation representative at least of the distribution of said inorganic sediments within said basin for said time interval is determined;
B. by means of a hydrological model and parameters of said hydrological model, said parameters of said hydrological model being constructed on the basis of said measurements and of said mesh representation, at least one unsaturated zone is delimited within said basin, said unsaturated zone corresponding to the vadose zone of said basin;
C. by means of a model of the accumulation of said organic matter and of parameters of said accumulation model, said parameters of said accumulation model comprising the thickness of said unsaturated zone in said time interval, the stability of said thickness of said unsaturated zone over said time interval, and the surface water flow in said time interval, said thickness of said unsaturated zone being stable if the following equation is satisfied:

$$Su = SR + SL$$

where SL is a rate of eustatic change, SR is a rate of sedimentation relative to the deposition of said organic and inorganic sediments, and Su is a rate of subsidence, at least one zone of accumulation of said terrestrial organic matter within said basin and an amount of terrestrial organic matter accumulated in said accumulation zone are determined;

and **in that**, on the basis of said amount of terrestrial organic matter accumulated and of said mesh representation, the petroleum potential of said basin is quantified, an exploration plan for said basin is defined, and said basin is exploited according to said plan.

**2.** Method according to Claim 1, in which each of the cells of said mesh representation determined by means of said stratigraphic simulator comprises at least one property relating to the lithological facies of said inorganic sediments of said cell.

**3.** Method according to Claim 2, in which said parameters of said hydrological model comprise the hydraulic conductivity in each cell of said mesh representation, said hydraulic conductivity in one of said cells being determined at least on the basis of said property relating to the lithological facies of said organic sediments in said cell.

**4.** Method according to one of the preceding claims, in which said hydrological model delimits a saturated zone of said basin by taking pressure gradients in said basin into account, and defines the base of said unsaturated zone by the ceiling of said saturated zone.

**5.** Method according to one of the preceding claims, in which a cell of said mesh representation is included in a zone of potential accumulation of said terrestrial organic matter if:

- said thickness of said unsaturated zone in said time interval is at most equal to 1 m; and
- said surface water flow is at most equal to 10 $m^3$/s.

**6.** Method according to one of the preceding claims, in which said amount of terrestrial organic matter accumulated is determined on the basis of a rate of accumulation of said terrestrial organic matter TAM, said rate of accumulation of said terrestrial organic matter TAM being determined according to the formula:

$$TAM = Su - SRin - SL$$

when $Su - SRin - SL \leq X$, where $SL$ is said rate of eustatic change, $SRin$ is a rate of sedimentation relative to the deposition of said inorganic sediments, X is a rate of sedimentation of said organic matter and $Su$ is said rate of subsidence.

7. Computer program product that can be downloaded from a communication network and/or is stored on a medium that can be read by computer and/or can be executed by a processor, comprising program code instructions for implementing the method according to one of the preceding claims, when said program is run on a computer.

**Figure 1**

**Figure 2**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 2743738 A
- US 20140163883 A
- EP 3104199 A

**Littérature non-brevet citée dans la description**

- **BOHACS, K ; SUTER, J.** Sequence Stratigraphic Distribution of Coaly Rocks: Fundamental Controls and Paralic Examples. *AAPG Bulletin,* Octobre 1997, vol. 81 (10), 1612-1639
- Concepts and applications of a 3D multiple lithology, diffusive model in stratigraphic modeling. **GRANJEON D. ; JOSEPH P.** Numerical Experiments in Stratigraphy: Recent Advances in Stratigraphic and Sedimentologic Computer Simulations. SEPM Special Publications, 1999, vol. 62, 197-210
- Modelling source rock distribution and quality variations: The OF-Mod approach. In: Analogue and Numerical Forward Modelling of Sedimentary Systems; from Understanding to Prediction. **MANN, U. ; ZWEIGEL, J.** Special Publication 40 of the International Association of Sedimentologists. 2008, 239-274